(19) Europäisches Patentamt
European Patent Office
Office européen des brevets

(11) **EP 3 503 166 B1**

(12) **FASCICULE DE BREVET EUROPEEN**

(45) Date de publication et mention
de la délivrance du brevet:
**02.12.2020 Bulletin 2020/49**

(51) Int Cl.:
***H01L 21/304*** *(2006.01)*     *H01L 21/762* *(2006.01)*

(21) Numéro de dépôt: **18213867.7**

(22) Date de dépôt: **19.12.2018**

(54) **PROCÉDÉ DE DÉTOURAGE DE PLAQUE**

VERFAHREN ZUM KONTURFRÄSEN EINER PLATTE

PLATE TRIMMING METHOD

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **22.12.2017 FR 1763150**

(43) Date de publication de la demande:
**26.06.2019 Bulletin 2019/26**

(73) Titulaire: **Commissariat à l'Energie Atomique et
aux Energies
Alternatives
75015 Paris (FR)**

(72) Inventeurs:
• **FOURNEL, Frank
38190 VILLARD-BONNOT (FR)**
• **MORALES, Christophe
38220 St Pierre de Mesage (FR)**
• **ZUSSY, Marc
38120 SAINT EGREVE (FR)**

(74) Mandataire: **Bronchart, Quentin
Cabinet Hautier
20, rue de la Liberté
06000 Nice (FR)**

(56) Documents cités:
**EP-A1- 2 348 527     US-A1- 2014 042 595**

EP 3 503 166 B1

## Description

DOMAINE TECHNIQUE DE L'INVENTION

L'invention concerne le domaine des microtechnologies et de la microélectronique. Elle trouve pour application particulièrement avantageuse le détourage de plaques pour la microélectronique.

ÉTAT DE LA TECHNIQUE

Dans le domaine de la microélectronique, les plaques utilisées comme substrats peuvent être fabriquées par l'intermédiaire d'étapes de collage et/ou de transfert de couches.

Par exemple, un substrat de type « Silicium sur Isolant » (SOI pour l'acronyme anglais « Silicon On Insulator ») peut être fabriqué à partir d'un procédé de fabrication par adhésion moléculaire, également dénommé collage direct.

Selon ce procédé de collage direct, la surface d'une première couche de dioxyde de silicium sur une première plaque de silicium, est mise en contact avec la surface d'une deuxième couche de dioxyde de silicium sur une deuxième plaque de silicium, après préparation des surfaces. Un traitement thermique approprié est effectué de sorte à solidariser les deux plaques au niveau des couches d'oxyde en contact.

Un amincissement de la première plaque de silicium est ensuite réalisé par meulage et/ou polissage mécano-chimique, de sorte à former un substrat de type SOI.

Cependant, lors du collage direct, des zones en périphérie des plaques restent non collées. Ces zones en périphérie sont donc fragiles et susceptibles de se casser de façon non contrôlée lors de l'amincissement. Ces zones en périphérie peuvent ainsi être source de contamination particulaire du substrat SOI.

Pour remédier à ce problème, les zones en périphérie de la plaque à amincir sont en général préalablement éliminées par un procédé de détourage.

Le procédé de détourage peut consister à usiner mécaniquement le bord de la plaque à amincir fixée sur la plaque support. Cependant, il est difficile d'usiner la plaque à amincir sans toucher ou endommager la plaque support. En effet, l'interface entre les deux plaques collées est généralement mince et il est souvent impossible de contrôler l'arrêt de l'usinage en fonction d'une profondeur d'usinage de manière suffisamment précise.

Ainsi, pour éliminer complètement les zones en périphérie de la plaque à amincir, le détourage par usinage mécanique conduit généralement à détourer également une partie de la plaque support sur une faible épaisseur, comme illustré dans le document WO 1996017377 A1 par exemple.

Un inconvénient de ce procédé est que la plaque support, partiellement usinée à l'issue du détourage, n'est pas réutilisable.

Un autre inconvénient majeur de ce procédé est la source de contamination particulaire engendrée par l'usinage partiel de la plaque support.

Un procédé de détourage mixte comprenant une première étape de détourage partiel mécanique suivi d'une étape de gravure chimique sélective est illustré dans le document EP 2348527 A1. Un tel procédé nécessite deux étapes mécanique et chimique. Cela augmente le temps du procédé de détourage. Cela augmente le coût du procédé de détourage.

Alternativement, le détourage peut être réalisé par des techniques de photolithographie et de gravure profonde. Un tel procédé de détourage par usinage physico-chimique est cependant lent et coûteux.

Un objet de la présente invention est de pallier les inconvénients des procédés de détourage mentionnés ci-dessus.

En particulier, un objet de la présente invention est de proposer un procédé de détourage d'une plaque collée sur une plaque support, limitant voire annulant une contamination particulaire issue de la plaque support.

RÉSUMÉ DE L'INVENTION

Pour atteindre cet objectif, la présente invention prévoit un procédé de détourage d'une plaque présentant une première face et une deuxième face opposée à la première face, le procédé comprenant au moins les étapes suivantes :

- Fixer la plaque sur un support au moyen d'une couche, dite couche d'interface, située entre la plaque et le support, au niveau de la première face,
- Rogner une zone en pourtour de la plaque par meulage à partir de la deuxième face et en direction de la couche d'interface,
- Arrêter le rognage après enlèvement de la zone en pourtour au bout d'un temps total de meulage $t_{tot}$.

De manière avantageuse, une couche d'interface comprenant une couche, dite couche de transition, située au moins au droit de la zone en pourtour de la plaque et présentant une résistance au meulage supérieure à celle de la plaque, est utilisée, et l'arrêt du rognage est opéré dans ladite couche de transition après détection d'une variation de résistance au meulage.

L'utilisation d'une couche de transition présentant une résistance au meulage supérieure, et de préférence au moins cinq fois supérieure, à celle de la plaque à détourer permet avantageusement de freiner une progression du meulage au travers de la couche d'interface. Il est dès lors possible d'arrêter le rognage dans la couche d'interface, voire dans la couche de transition.

Le procédé proposé par la présente invention permet ainsi d'éviter une source de contamination particulaire issue du support, en protégeant le support vis-à-vis du meulage.

La plaque support ainsi préservée peut en outre être avantageusement réutilisée, pour d'autres applications ou pour le détourage d'une autre plaque.

Selon une possibilité avantageuse, l'arrêt du rognage est opéré après détection d'une variation de résistance au meulage. Cette variation de résistance est en effet due à la présence de la couche de transition, et indique que le meulage a atteint ladite couche de transition.

BRÈVE DESCRIPTION DES FIGURES

Les buts, objets, ainsi que les caractéristiques et avantages de l'invention ressortiront mieux de la description détaillée de modes de réalisation de cette dernière qui sont illustrés par les dessins d'accompagnement suivants dans lesquels :

- La FIGURE 1A illustre un état initial du procédé de détourage selon un mode de réalisation de l'invention, en cours de réalisation ;
- La FIGURE 1B montre une progression du procédé de détourage selon un mode de réalisation de l'invention illustré à la figure 1A ;
- La FIGURE 1C montre le procédé de détourage selon un mode de réalisation de l'invention illustré à la figure 1A, en cours de finalisation ;
- La FIGURE 2A illustre un procédé de détourage selon un premier mode de réalisation de l'invention ;
- La FIGURE 2B montre une vue en coupe transversale d'un substrat obtenu à l'issue du procédé de détourage selon le premier mode de réalisation de l'invention illustré à la figure 2A ;
- La FIGURE 3A illustre un procédé de détourage selon un deuxième mode de réalisation de l'invention ;
- La FIGURE 3B montre une vue en coupe transversale d'un substrat obtenu à l'issue du procédé de détourage selon le deuxième mode de réalisation de l'invention illustré à la figure 3A ;
- La FIGURE 4 montre un diagramme de procédé illustrant des étapes d'un procédé de détourage selon un mode de réalisation de l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches et plaques ne sont pas représentatives de la réalité.

DESCRIPTION DÉTAILLÉE DE L'INVENTION

Avant d'entamer une revue détaillée de modes de réalisation de l'invention, sont énoncées ci-après des caractéristiques optionnelles qui peuvent éventuellement être utilisées en association ou alternativement :

- La couche de transition est choisie en un matériau pris parmi : un oxyde de silicium, de l'alumine, du diamant, du nitrure de silicium.
- La couche de transition est choisie pour présenter une épaisseur comprise entre 0,5 $\mu$m et 10 $\mu$m.
- La plaque est choisie en au moins un matériau pris parmi : du silicium, du germanium, un matériau III/V, un matériau II/VI, du carbure de silicium (SiC).
- Le temps de meulage total $t_{tot}$ est choisi tel que $t_{tot}$ = $t_1$ + $t_2$, $t_1$ étant un premier temps de meulage correspondant à un meulage de la zone en pourtour de la plaque et $t_2$ étant un deuxième temps de meulage correspondant à un meulage partiel de la couche de transition, où $t_2 \neq 0$, de sorte que l'arrêt du rognage au bout du temps total de meulage $t_{tot}$ est opéré dans ladite couche de transition.

Selon un mode de réalisation particulièrement avantageux pour l'arrêt du rognage par détection d'une variation de résistance au meulage, en particulier dans le cas d'un rognage effectué selon une consigne imposant une vitesse de descente de meule donnée :

- La variation de résistance au meulage est détectée comme une augmentation de l'un parmi un ampérage nominal et un couple nominal du moteur d'une meule de broyage.
- L'augmentation d'ampérage du moteur est une augmentation d'au moins 30 % de l'ampérage nominal lors du meulage.

Une telle augmentation de l'ampérage nominal ou du couple nominal du moteur de la meule indique que la meule a atteint la couche de transition. La détection de cette augmentation permet de commander l'arrêt du rognage.

Selon un autre mode de réalisation particulièrement avantageux pour l'arrêt du rognage par détection d'une variation de résistance au meulage, en particulier dans le cas d'un rognage effectué selon une consigne imposant un couple du moteur de meule donné :

- La variation de résistance au meulage est détectée comme une diminution d'une vitesse de descente nominale d'une meule de broyage.
- La diminution de vitesse de descente est une diminution d'au moins 50 % de la vitesse de descente nominale lors du meulage.

Une telle diminution de vitesse de descente de la meule indique également que la meule a atteint la couche de transition. La détection de cette diminution permet de commander l'arrêt du rognage. La diminution de vitesse peut être mesurée à partir de la position de la meule. Dès lors que la meule cesse de progresser au contact de la couche de transition, sa vitesse de descente diminue brutalement.

Selon un mode de réalisation alternatif aux précédents modes de réalisation :

- Le temps total $t_{tot}$ est déterminé par majoration par un facteur $k_1$ d'un temps prédictible de meulage $t_{préd}$ tel que $t_{tot} = k_1 . t_{préd}$, avec $1,1 < k_1 < 3$, ledit temps prédictible étant prédit en fonction d'au moins un taux d'enlèvement du matériau de la zone en pourtour de manière à enlever une épaisseur totale $e_{tot}$ de ladite zone en pourtour.

L'arrêt du rognage est ainsi avantageusement programmé sans qu'il soit nécessaire de détecter un passage de la meule au niveau de la couche de transition. La couche de transition présente en outre une résistance au meulage suffisante pour empêcher un meulage de la plaque support dans un tel cas où le meulage est prolongé au-delà du temps nécessaire pour enlever la zone en pourtour sur toute son épaisseur.

Selon un mode de réalisation avantageux compatible avec les précédents modes de réalisation, mais uniquement optionnel :

- Le rognage comprend une première étape de meulage configurée pour enlever une première partie de la zone en pourtour avec un taux d'enlèvement compris entre 10 $\mu$m.min$^{-1}$ et 100 $\mu$m.min$^{-1}$, ladite première partie comprenant au moins 90 %, de préférence au moins 95 %, voire 97%, de la zone en pourtour, et une deuxième étape de meulage succédant à la première étape de meulage et configurée pour enlever une deuxième partie de la zone en pourtour avec un taux d'enlèvement compris entre 1 $\mu$m.min$^{-1}$ et 10 $\mu$m.min$^{-1}$.
- EN complément, la première étape de meulage peut être effectuée sur une largeur $L_1$ prise depuis un bord de la zone en pourtour, et la deuxième étape de meulage est effectuée sur une largeur $L_2$ prise depuis ledit bord de la zone en pourtour, tel que $L_1 > L_2$.

Ce mode de réalisation permet de minimiser le temps total de meulage en recourant à une première étape de meulage rapide.

- Selon un mode de réalisation alternatif au complément précédent, la première étape de meulage est effectuée sur une largeur $L_1$ prise depuis un bord de la zone en pourtour, et la deuxième étape de meulage est effectuée sur une largeur $L_2$ prise depuis ledit bord de la zone en pourtour, tel que $L_1 < L_2$.

Ce mode de réalisation permet d'obtenir un bord de détourage de la plaque sensiblement vertical, en évitant de créer une marche ou un piétement au niveau du bord de détourage après la première étape de meulage.

- Les largeurs $L_1$ et $L_2$ sont comprises entre 1 mm et 5 mm.

Selon un mode de réalisation particulièrement avantageux et compatible avec les précédents modes de réalisation :

- Le procédé de détourage comprend en outre, après l'arrêt du rognage, une étape de nettoyage par gravure de sorte à enlever une partie éventuellement restante de la zone en pourtour.
- La gravure peut être une gravure humide telle que, par exemple, une gravure en solution à base d'hydroxyde de tetramethylammonium (TMAH) à une température comprise entre 70°C et 90°C pendant un temps de gravure compris entre 5 min et 15 min.

Cette gravure humide présente une bonne sélectivité Si/SiO$_2$. Elle peut donc être notamment utilisée pour le détourage d'une plaque en silicium et pour une couche de transition en SiO$_2$.

- En alternative, la gravure peut être une gravure sèche telle que, par exemple, une gravure par plasma à base d'hexafluorure de soufre (SF$_6$) pendant un temps de gravure compris entre 5 min et 15 min.

Cette gravure sèche présente une bonne sélectivité Si/SiO$_2$. Elle peut donc être notamment utilisée pour le détourage d'une plaque en silicium et pour une couche de transition en SiO$_2$.

Il est précisé que, dans le cadre de la présente invention, le rognage se fait par meulage. Ce rognage est donc un procédé d'enlèvement ou d'amincissement purement mécanique, contrairement à un procédé de polissage mécano-chimique (CMP pour l'acronyme anglais « Chemical-Mechanical Polishing »). Un procédé de polissage mécano-chimique combine en effet des actions chimiques et mécaniques, en mélangeant généralement un abrasif libre à une solution de gravure humide.

Le meulage, dans le cadre de la présente invention, est mis en œuvre sans ajout d'abrasif libre, ni ajout de solution de gravure chimique.

Un procédé de meulage purement mécanique se distingue donc des procédés de type CMP.

Dans la suite, les termes « rognage », « meulage » et « usinage par abrasion » sont synonymes.

Le meulage consiste à abraser un matériau par frottement avec des grains ou des particules coupantes agglomérées par un liant au moins en surface d'un outil. En particulier, une roue diamantée mise en rotation sur une meule permet d'effectuer un tel usinage par abrasion.

Le meulage peut être assisté par un flux d'eau de manière à limiter un échauffement des matériaux en frottement, et/ou de manière à charrier, par une action physique, des particules de matériau abrasé. Ce flux d'eau n'est pas destiné à assister le meulage par une action chimique.

La résistance à l'abrasion d'un matériau A peut dépendre de la nature du matériau abrasif B et de la nature du liant, des différents mouvements de frottement sur la surface du matériau A, de la contrainte interne du matériau A, et de la pression de contact entre le matériau abrasif B et le matériau A notamment.

La résistance à l'abrasion du matériau A peut être évaluée au travers d'un taux d'enlèvement de ce matériau A, à partir de paramètres de meulage fixés, tels que la taille de grain du matériau abrasif B, la nature du liant, une vitesse de rotation de la roue de meulage, et une pression appliquée au matériau A par ladite roue par exemple.

On entend par un film, une couche, « à base » d'un matériau A, un film, une couche comprenant ce matériau A uniquement ou ce matériau A et éventuellement d'autres matériaux, par exemple des éléments d'alliage, des impuretés ou des éléments dopants.

Dans la présente demande de brevet, l'épaisseur est prise selon une direction perpendiculaire aux faces principales des plaques en contact. Sur les figures, l'épaisseur est prise selon l'axe z des repères orthonormés xyz.

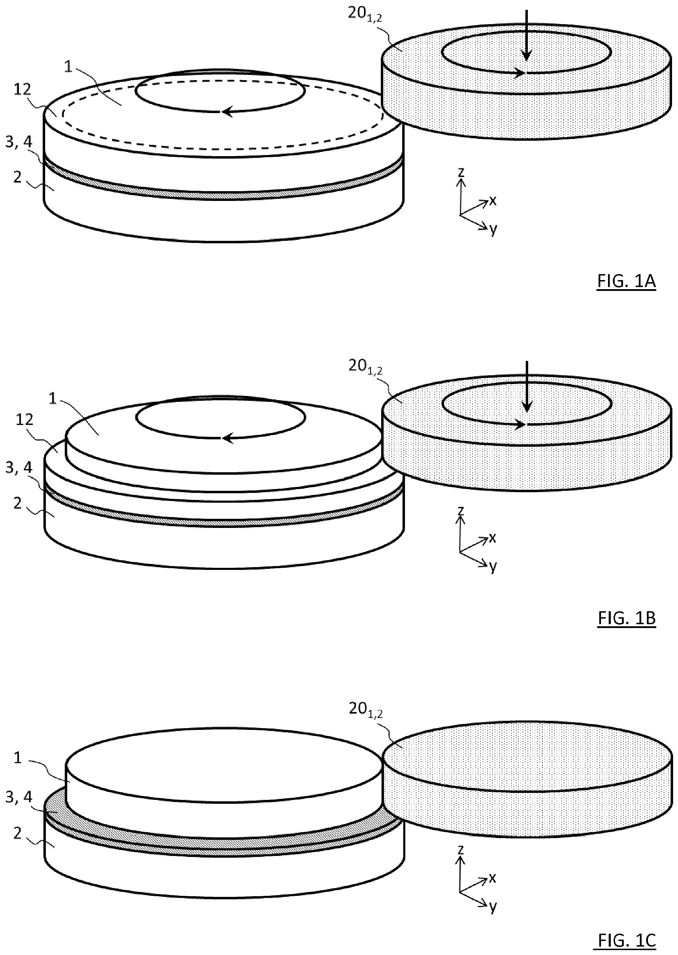

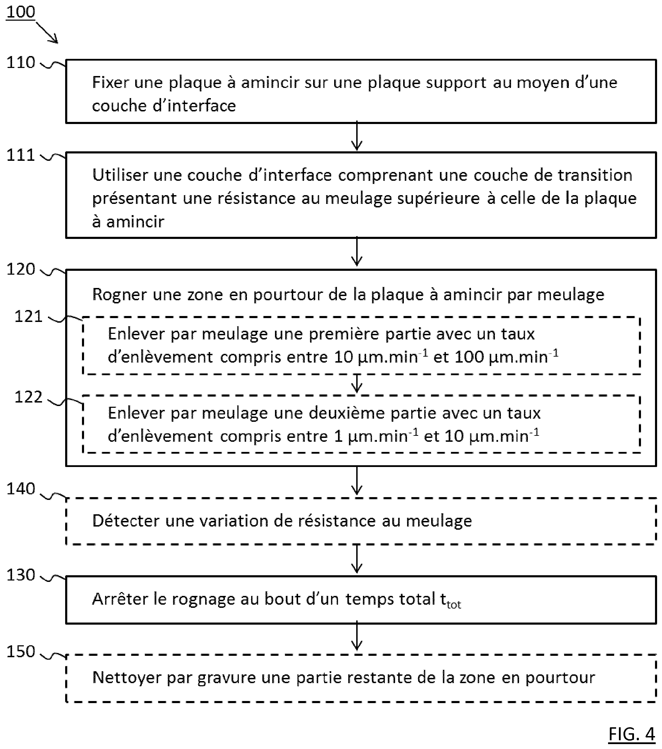

En référence aux figures 1A, 1B, 1C, et 4, le procédé 100 de détourage selon l'invention concerne le détourage d'une plaque à amincir 1 fixée 110 sur une plaque support 2 par l'intermédiaire d'une couche d'interface 3. L'empilement comprenant la plaque 1 à amincir, la couche d'interface 3 et la plaque support 2 peut être appelé « substrat ».

La plaque à amincir 1 peut être fixée 110 par collage direct sur la plaque support 2.

Un premier exemple de collage direct entre une première plaque et une deuxième plaque est décrit ci-après.

La première plaque, par exemple la plaque à amincir 1, est une plaque de silicium présentant une épaisseur de 775 $\mu$m, oxydée thermiquement au moins sur une face de sorte à former une couche d'oxyde de 1 $\mu$m d'épaisseur.

La deuxième plaque, par exemple la plaque support 2, est une plaque de silicium de 775 $\mu$m d'épaisseur, oxydée thermiquement au moins sur une face de sorte à former une couche d'oxyde de 1 $\mu$m d'épaisseur.

Ensuite, une étape de préparation de surface des première et deuxième plaques, comprenant par exemple un nettoyage et une hydrolyse, peut être réalisée. Un tel nettoyage peut être réalisé par exemple dans un bain d'eau désionisée enrichie en ozone. Une telle hydrolyse peut être réalisée par exemple dans une solution de peroxyde d'ammonium (APM pour l'acronyme anglais « Ammonium peroxide mixture ») à 70°C.

Après préparation des surfaces, la face comprenant l'oxyde de la première plaque est mise en contact avec la face comprenant l'oxyde de la deuxième plaque, à température et pression ambiantes.

Un recuit à 1200°C pendant deux heures peut ensuite être effectué de manière à finaliser le collage direct par adhésion moléculaire.

Un deuxième exemple de collage direct entre une première plaque et une deuxième plaque est également décrit ci-après.

La première plaque, par exemple la plaque à amincir 1, est une plaque de silicium de 775 $\mu$m d'épaisseur, comprenant des dispositifs microélectroniques sur une face. Un dépôt d'oxyde, par exemple par dépôt chimique en phase vapeur (CVD) à partir d'un précurseur TEOS (tetraethylorthosilicate), est réalisé sur ladite face de sorte à former une couche d'oxyde de 5 $\mu$m d'épaisseur.

La deuxième plaque, par exemple la plaque support 2, est une plaque de silicium de 775 $\mu$m d'épaisseur, comprenant éventuellement des dispositifs microélectroniques sur une face. Un dépôt d'oxyde, par exemple par CVD à partir d'un précurseur TEOS, est réalisé sur ladite face de sorte à former une couche d'oxyde de 5 $\mu$m d'épaisseur.

Ensuite, une étape de préparation de surface des première et deuxième plaques, semblable à celle décrite dans le premier exemple précédent, peut être réalisée.

Après préparation des surfaces, la face comprenant l'oxyde de la première plaque est mise en contact avec la face comprenant l'oxyde de la deuxième plaque, à température et pression ambiantes.

Un recuit à 400°C pendant deux heures peut ensuite être effectué de manière à finaliser le collage direct par adhésion moléculaire. Cette température permet de ne pas endommager les dispositifs microélectroniques présents.

Dans ces exemples de collage direct, la couche d'interface 3 est issue des couches d'oxydes des première et deuxième plaques.

La plaque à amincir 1 peut dès lors s'entendre d'une partie de la première plaque excluant la couche d'interface 3.

Dans la suite, la plaque à amincir 1 est également dénommée plaque supérieure ou simplement plaque 1.

Après collage, la face libre de la plaque supérieure 1 est dénommée face supérieure.

La plaque à amincir 1 peut être en un matériau pris parmi : du silicium, du germanium, un matériau III/V, un matériau II/VI, du SiC. Cette liste n'est cependant pas exhaustive.

Tel qu'illustré aux figures 1A, 1B et 1C, le détourage de la plaque 1 est réalisé de préférence au moyen d'une meule comprenant au moins une roue diamantée $20_1$, $20_2$.

Un rognage 120, ou meulage, d'une zone en pourtour 12 de la plaque supérieure 1 est effectué.

Un tel meulage 120 peut comprendre par exemple les étapes suivantes :
Les plaques 1, 2 collées et la roue diamantée $20_1$, $20_2$ sont respectivement mises en rotation selon des sens de rotation de préférence opposés, tel qu'illustré par les flèches sur les figures.

La roue diamantée $20_1$, $20_2$ est approchée de la face supérieure de la plaque 1, de sorte à obtenir un recouvrement, en projection dans un plan xy, sur une largeur, $L_1$ ou $L_2$, prise depuis un bord de la plaque 1.

Une force, illustrée par une flèche verticale sur les figures, est ensuite appliquée à la roue selon la direction z, de sorte à meuler 120 progressivement la zone en pourtour 12, en déplaçant verticalement la meule depuis la face supérieure en direction de la couche d'interface 3.

La zone en pourtour 12 peut être sensiblement annulaire et peut présenter une largeur $L_1$, $L_2$, prise radialement, comprise entre 1 mm et 5 mm.

L'épaisseur de cette zone en pourtour 12 est de préférence égale à l'épaisseur totale $e_{tot}$ de la plaque supérieure 1.

Le procédé de détourage 100 vise à éliminer la zone en pourtour 12 sur toute son épaisseur.

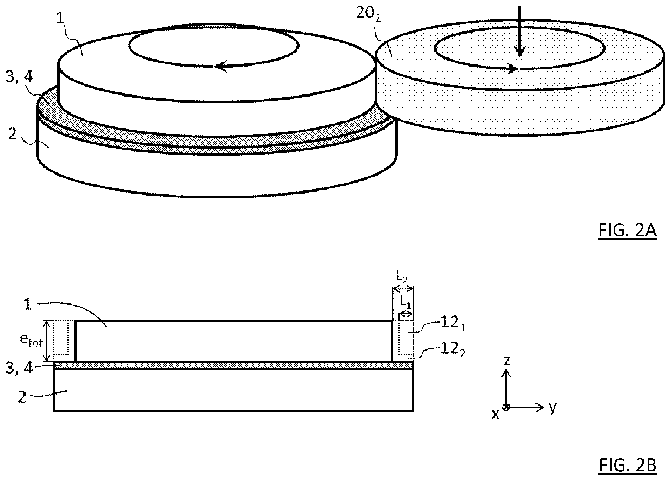

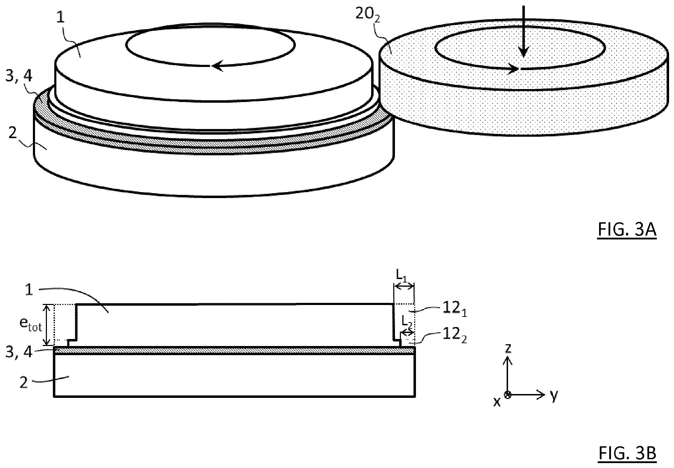

Pour ce faire, selon un mode de réalisation du procédé 100 en partie illustré aux figures 2A, 2B et 3A, 3B, le rognage 120 comprend une première étape de meulage 121 et une deuxième étape de meulage 122 succédant à la première étape de meulage 121.

La première étape de meulage 121 est configurée pour enlever une première partie $12_1$ de la zone en pourtour 12 sur une largeur $L_1$ avec, comme consigne, un premier taux d'enlèvement. La première partie $12_1$ comprend au moins 90 %, de préférence au moins 97 %, de la zone en pourtour 12.

La deuxième étape de meulage 122 est configurée pour enlever une deuxième partie $12_2$ de la zone en pourtour 12 sur une largeur $L_2$ avec, comme consigne, un deuxième taux d'enlèvement inférieur au premier taux d'enlèvement.

Le premier taux d'enlèvement peut être typiquement compris entre 10 $\mu$m.min$^{-1}$ et 100 $\mu$m.min$^{-1}$, et le deuxième taux d'enlèvement peut être typiquement compris entre 1 $\mu$m.min$^{-1}$ et 10 $\mu$m.min$^{-1}$.

La première étape de meulage 121 permet ainsi de meuler rapidement une majeure partie $12_1$ de la zone en pourtour 12, la partie restante $12_2$ étant meulée 122 plus lentement à l'approche de la couche d'interface 3.

Les première et deuxième étapes de meulage 121, 122 cumulent un temps total de meulage $t_{tot}$.

La première étape de meulage 121 est par exemple réalisée par une première meule, par exemple de marque Okamoto, modèle 254B 3W5X J 75BA 325 40SB8, avec une roue diamantée $20_1$ présentant une taille de grain 16000/325 $\mu$m, sur une largeur $L_1$ de 3 mm en pourtour de la plaque 1.

Cette première étape 121 est arrêtée lorsque la roue $20_1$ atteint une potion verticale distante d'environ 20 $\mu$m de la couche d'interface 3.

Une deuxième étape de meulage 122 peut alors être réalisée par une deuxième meule, par exemple de marque Okamoto, modèle 254B 3W5X J 75BA 2000 40SB8, avec une roue diamantée $20_2$ présentant une taille de grain plus fine que celle de l'étape précédente, typiquement 16000/2000 $\mu$m, sur une largeur $L_2$ en pourtour de la plaque 1.

La largeur $L_2$ peut être égale à $L_1$, ou comprise dans un intervalle $L_1 \pm 0,1$ mm.

Avantageusement, la largeur $L_2$ sera légèrement inférieure à $L_1$, par exemple comprise entre $L_1$-0,01 mm > $L_2$ > $L_1$-0,1 mm, pour minimiser le temps total de meulage et/ou éviter une trop grande consommation de roues diamantées $20_2$ à grains fins.

Le procédé de détourage 100 vise également à arrêter le meulage 120 au niveau de la couche d'interface 3.

Pour ce faire, une couche d'interface 3 comprenant une couche de transition 4 présentant une résistance au meulage, ou une résistance à l'abrasion, supérieure à celle de la plaque 1 est avantageusement utilisée 111.

La couche de transition 4 présente de préférence une épaisseur inférieure ou égale à celle de l'interface 3.

Elle peut s'étendre selon toute une surface de la couche d'interface 3. Alternativement, elle peut s'étendre sur une zone sous-jacente à la zone en pourtour 12, par exemple annulaire.

La couche de transition 4 peut avantageusement constituer entièrement la couche d'interface 3.

Cette couche de transition 4 peut présenter une résistance à l'abrasion au moins trois ou cinq fois supérieure, et de préférence au moins dix fois supérieure, à celle de la plaque 1.

La résistance à l'abrasion de la couche de transition 4 et la résistance à l'abrasion de la plaque 1 peuvent être évaluées à partir des taux d'enlèvement des matériaux constituant respectivement la couche de transition 4 et la plaque 1, pour un jeu de paramètres de meulage fixé.

Ce jeu de paramètres comprend notamment une taille de grain du matériau abrasif, une vitesse de rotation de la roue de meulage, une pression appliquée au matériau à meuler, et optionnellement une vitesse de rotation du support sur lequel est fixé le matériau à meuler et un sens de rotation dudit support relativement au sens de rotation de la roue.

Par exemple, un meulage d'une zone en pourtour 12 en silicium effectué par une roue diamantée $20_2$ présentant une taille de grain 16000/2000 $\mu$m, à une vitesse de rotation de la roue $20_2$ de 2000 tr.min$^{-1}$ permet d'abraser le silicium avec un taux d'enlèvement compris entre 10 $\mu$m.min$^{-1}$ et 20 $\mu$m.min$^{-1}$.

Un meulage d'une zone sous-jacente (à la zone en pourtour 12) en oxyde de silicium effectué dans les mêmes conditions que le meulage de la zone en pourtour 12 en silicium, permet d'abraser l'oxyde de silicium avec un taux d'enlèvement compris entre 0,05 $\mu$m.min$^{-1}$ et 0,1 $\mu$m.min$^{-1}$.

Pour une plaque à amincir 1 en silicium, une couche d'interface 3 comprenant une couche de transition 4 en oxyde de silicium peut donc avantageusement être utilisée 111, de manière à freiner significativement le meulage au niveau de la couche de transition 4.

L'arrêt 130 du meulage ou du rognage peut être effectué dans la couche de transition 4 au bout d'un temps total de meulage $t_{tot}$ supérieur à un premier temps de meulage $t_1$ correspondant au meulage de la zone en pourtour 12 sur toute son épaisseur.

Le temps total de meulage $t_{tot}$ peut ainsi être fixé tel que : $t_{tot} = t_1 + t_2$, avec $t_2 \neq 0$, $t_2$ étant un deuxième temps de meulage correspondant au meulage partiel de la couche de transition 4.

Pour un meulage avec une roue diamantée $20_1$ grossière puis une roue diamantée $20_2$ plus fine, comprenant une première et une deuxième étape de meulage 121, 122, avec $L_2 < L_1$, le premier temps de meulage $t_1$ correspond de préférence uniquement au meulage de la zone en pourtour 12 lors de la deuxième étape de meulage 122. Ce premier temps $t_1$ correspond dès lors au meulage de l'épaisseur d'une zone résiduelle de la zone en pourtour 12 après la première étape de meulage 121.

Avantageusement, le taux d'enlèvement dans la couche de transition 4 est très inférieur, de préférence inférieur d'au moins un ordre de grandeur, au taux d'enlèvement dans la zone de pourtour 12.

Ainsi, il n'est pas nécessaire de contrôler très précisément le premier temps de meulage $t_1$ pour éviter de meuler la couche d'interface 3 sur toute son épaisseur et notamment pour éviter de meuler une partie sous-jacente de la plaque support 2.

La couche de transition 4 permet de protéger la plaque support 2 vis-à-vis du meulage, au moins pendant le deuxième temps $t_2$.

La plaque support 2 peut donc être avantageusement réutilisée, après détourage et décollage de la plaque 1, pour le détourage d'une autre plaque par exemple.

Le premier temps de meulage $t_1$ peut être simplement estimé, d'après un abaque ou par calibration par exemple, et majoré par un coefficient $k_1$ de sorte que :

$$t_{tot} = t_1 + t_2 = k_1 . t_1 .$$

Pour un meulage avec une roue diamantée $20_1$ grossière puis une roue diamantée $20_2$ plus fine, $k_1$ est choisi de préférence tel que $2 < k_1 < 3$. La zone résiduelle, dont l'épaisseur correspond de préférence à environ 3 % de l'épaisseur totale de la zone en pourtour 12 à l'issue de la première étape de meulage 121, peut ainsi être totalement meulée lors de la deuxième étape de meulage 122.

Le deuxième temps de meulage $t_2$ est de préférence strictement inférieur à un temps de meulage $t_{2tot}$ correspondant au meulage de la couche de transition 4 sur toute son épaisseur.

De manière à ce que ce temps de meulage $t_{2tot}$ soit d'au moins quelques dizaines de secondes, le choix de la nature et de l'épaisseur de la couche de transition 4 est particulièrement important.

La couche de transition 4 est de préférence choisie en un matériau pris parmi : un oxyde de silicium, de l'alumine, du diamant et le nitrure de silicium.

La couche de transition 4 est de préférence choisie avec une épaisseur comprise entre 0,5 $\mu$m et 10 $\mu$m.

Selon un mode de réalisation particulièrement avantageux du procédé 100, une détection 140 d'une variation de résistance au meulage est effectuée pour déclencher l'arrêt 130 du meulage.

La variation de résistance au meulage est en effet induite par un début d'abrasion de la couche de transition 4. La résistance au meulage augmente en passant de la zone en pourtour 12 à la couche de transition 4.

Cette augmentation de résistance au meulage peut notamment engendrer une augmentation d'un ampérage du moteur de la meule, si le meulage est effectué selon une vitesse fixée de descente de meule.

Par exemple, lors d'une transition du meulage entre la zone en pourtour 12 en silicium et la zone sous-jacente en oxyde de silicium, l'ampérage du moteur peut passer de 7A à 11A.

En surveillant cet ampérage et en détectant 140 cette augmentation d'ampérage lors du meulage 120, il est possible d'identifier un moment où la roue diamantée $20_2$ atteint ou a atteint la couche de transition 4.

Alternativement, si le meulage est effectué à ampérage de moteur donné, l'augmentation de résistance au meulage peut engendrer une diminution d'une vitesse de descente de la meule. En détectant 140 cette diminution de vitesse de descente, il est également possible d'identifier le moment où la roue diamantée $20_2$ atteint ou a atteint la couche de transition 4.

Dès lors, l'arrêt 130 du meulage peut être immédiat ou différé.

En différant l'arrêt 130 du meulage, le matériau de la plaque 1 peut être totalement éliminé dans la zone en pourtour 12 de façon purement mécanique.

En arrêtant 130 le meulage au moment où la roue diamantée $20_2$ atteint la couche de transition 4, une partie du matériau de la plaque 1 peut subsister dans la zone en pourtour 12. Cette solution peut être choisie en particulier dans le cas d'une couche de transition 4 de faible épaisseur, afin d'assurer la protection de la plaque support 2.

Une étape optionnelle de nettoyage 150 peut être effectuée de manière à retirer le matériau restant dans la zone de pourtour 12.

Ce nettoyage 150 peut être une gravure, par voie humide ou par voie sèche, du matériau restant.

La gravure du matériau de la plaque 1 présente de préférence une bonne sélectivité $S_{mat1/mat4}$ vis-à-vis du matériau de la couche de transition 4. Cette sélectivité est par exemple supérieure à 5:1.

Par exemple, dans le cas d'une plaque 1 en silicium et d'une couche de transition 4 en oxyde de silicium, une gravure humide dans une solution à base de TMAH à 12 %, à une température de 80 °C pendant un temps de gravure de 10 min peut être effectuée de manière à retirer le silicium restant dans la zone de pourtour 12. Dans ce cas, la sélectivité entre le silicium et l'oxyde thermique de silicium $S_{Si/SiO2}$ est supérieure à 500 :1.

Alternativement, une gravure sèche par plasma à base de $SF_6$, pendant un temps de gravure de 10 min, peut être effectuée.

La sélectivité $S_{Si/SiO2}$ peut être dans ce cas supérieure à 10:1.

Au vu de la description qui précède, il apparaît clairement que l'invention propose un procédé particulièrement fiable et efficace pour détourer une plaque collée sur une plaque support en limitant, voire en annulant, tout risque de contamination particulaire issue de la plaque support.

L'invention n'est pas limitée aux modes de réalisations précédemment décrits et s'étend à tous les modes de réalisation couverts par les revendications.

**Revendications**

1. Procédé de détourage (100) d'une plaque (1) présentant une première face et une deuxième face opposée à la première face, ledit procédé (100) comprenant les étapes suivantes :

   - Fixer (110) la plaque (1) sur un support (2) au moyen d'une couche (3), dite couche d'interface, située entre la plaque (1) et le support (2), au niveau de la première face,
   - Rogner (120) une zone en pourtour (12) de la plaque (1) par meulage à partir de la deuxième face et en direction de la couche d'interface (3),
   - Arrêter (130) le rognage après enlèvement de la zone en pourtour (12) au bout d'un temps total de meulage $t_{tot}$,

   ledit procédé (100) étant **caractérisé en ce qu'**on utilise (111) une couche d'interface (3) comprenant une couche (4), dite couche de transition, située au moins au droit de la zone en pourtour (12) de la plaque (1) et présentant une résistance au meulage supérieure à celle de la plaque (1), et **en ce que** l'arrêt (130) du rognage est opéré dans ladite couche de transition (4), après détection (140) d'une variation de résistance au meulage.

2. Procédé de détourage (100) selon la revendication précédente, dans lequel la résistance au meulage de la couche de transition (4) est au moins cinq fois supérieure à la résistance au meulage de la plaque (1).

3. Procédé de détourage (100) selon l'une quelconque des revendications précédentes, dans lequel le temps de meulage total $t_{tot}$ est choisi tel que $t_{tot} = t_1$ + $t_2$, $t_1$ étant un premier temps de meulage correspondant à un meulage de la zone en pourtour (12) de la plaque (1) et $t_2$ étant un deuxième temps de meulage correspondant à un meulage partiel de la couche de transition (4), où $t_2 \neq 0$, de sorte que l'arrêt (130) du rognage est opéré dans ladite couche de transition (4).

4. Procédé de détourage (100) selon l'une quelconque des revendications précédentes, dans lequel la variation de résistance au meulage est détectée comme une augmentation de l'un parmi un ampérage nominal et un couple nominal du moteur d'une meule.

5. Procédé de détourage (100) selon l'une quelconque des revendications 1 à 3, dans lequel la variation de résistance au meulage est détecté comme une diminution d'une vitesse de descente nominale d'une meule.

6. Procédé de détourage (100) selon l'une quelconque des revendications précédentes, dans lequel le rognage (120) comprend une première étape de meulage (121) configurée pour enlever une première partie ($12_1$) de la zone en pourtour (12) avec un taux d'enlèvement compris entre 10 $\mu$m.min$^{-1}$ et 100 $\mu$m.min$^{-1}$, ladite première partie ($12_1$) comprenant au moins 90 % de la zone en pourtour (12), et une deuxième étape de meulage (122) succédant à la première étape de meulage (121) et configurée pour enlever une deuxième partie ($12_2$) de la zone en pourtour (12) avec un taux d'enlèvement compris entre 1 $\mu$m.min$^{-1}$ et 10 $\mu$m.min$^{-1}$.

7. Procédé de détourage (100) selon la revendication précédente, dans lequel la première étape de meulage (121) est effectuée sur une largeur $L_1$ prise depuis un bord de la zone en pourtour (12), et la deuxième étape de meulage (122) est effectuée sur une largeur $L_2$ prise depuis ledit bord de la zone en pourtour (12), tel que $L_1 > L_2$.

8. Procédé de détourage (100) selon l'une quelconque des deux revendications précédentes, dans lequel les largeurs $L_1$ et $L_2$ sont comprises entre 1 mm et 5 mm.

9. Procédé de détourage (100) selon l'une quelconque des revendications précédentes comprenant en outre, après l'arrêt (130) du rognage, une étape de nettoyage (150) par gravure humide, par exemple de sorte à enlever une partie restante de la zone en pourtour (12).

10. Procédé de détourage (100) selon l'une quelconque des revendications 1 à 8 comprenant en outre, après l'arrêt (130) du rognage, une étape de nettoyage (150) par gravure sèche, par exemple de sorte à enlever une partie restante de la zone en pourtour (12).

11. Procédé de détourage (100) selon l'une quelconque des revendications précédentes, dans lequel la couche de transition (4) est choisie en un matériau pris parmi : un oxyde de silicium, de l'alumine, du diamant, du nitrure de silicium, et dans lequel la plaque (1) est choisie en au moins un matériau pris parmi : du silicium, du germanium, un matériau III/V, un matériau II/VI, du carbure de silicium.

12. Procédé de détourage (100) selon l'une quelconque des revendications précédentes, dans lequel la couche de transition (4) est choisie pour présenter une épaisseur comprise entre 0,5 $\mu$m et 10 $\mu$m.

**Patentansprüche**

1. Verfahren zum Konturenfräsen (100) einer Platte (1), die eine erste Seite und eine der ersten Seite gegenüberliegende zweite Seite aufweist, wobei das Verfahren (100) die folgenden Schritte umfasst:

   - Befestigen (110) der Platte (1) im Bereich der ersten Seite an einem Träger (2) mittels einer als Zwischenschicht bezeichneten Schicht (3), die sich zwischen der Platte (1) und dem Träger (2) befindet,
   - Zuschneiden (120) einer Umfangszone (12) der Platte (1) durch Schleifen ausgehend von der zweiten Seite und in Richtung der Zwischenschicht (3),
   - Stoppen (130) des Zuschneidens nach Abtragen der Umfangszone (12) am Ende einer Gesamtschleifzeit $t_{tot}$,

   wobei das Verfahren (100) **dadurch gekennzeichnet ist, dass** eine Zwischenschicht (3) verwendet (111) wird, die eine als Übergangsschicht bezeichnete Schicht (4) umfasst, welche sich mindestens an der Umfangszone (12) der Platte (1) befindet und einen Schleifwiderstand aufweist, der höher ist als jener der Platte (1), und dadurch, dass das Stoppen (130) des Zuschneidens in der Übergangsschicht (4) nach Erkennen (140) einer Änderung des Schleifwiderstands erfolgt.

2. Konturenfräsverfahren (100) nach dem vorstehenden Anspruch, wobei der Schleifwiderstand der Übergangsschicht (4) mindestens fünfmal höher ist als der Schleifwiderstand der Platte (1).

3. Konturenfräsverfahren (100) nach einem der vorstehenden Ansprüche, wobei die Gesamtschleifzeit $t_{tot}$ so gewählt ist, dass $t_{tot} = t_1 + t_2$, wobei $t_1$ eine erste Schleifzeit ist, die einem Schleifen der Umfangszone (12) der Platte (1) entspricht, und $t_2$ eine zweite Schleifzeit ist, die einem teilweisen Schleifen der Übergangsschicht (4) entspricht, wobei $t_2 \neq 0$, sodass das Stoppen (130) des Zuschneidens in der Übergangsschicht (4) erfolgt.

4. Konturenfräsverfahren (100) nach einem der vorstehenden Ansprüche, wobei die Änderung des Schleifwiderstands als eine Zunahme von einem aus einer Nennstromstärke und einem Nennmoment des Motors eines Schleifers erkannt wird.

5. Konturenfräsverfahren (100) nach einem der Ansprüche 1 bis 3, wobei die Änderung des Schleifwiderstands als eine Abnahme einer Nennsinkgeschwindigkeit eines Schleifers erkannt wird.

6. Konturenfräsverfahren (100) nach einem der vorstehenden Ansprüche, wobei das Zuschneiden (120) einen ersten Schleifschritt (121) umfasst, der so ausgebildet ist, dass ein erster Teil ($12_1$) der Umfangszone (12) mit einer Abtragrate im Bereich zwischen 10 $\mu$m.min$^{-1}$ und 100 $\mu$m.min$^{-1}$ abgetragen wird, wobei der erste Teil ($12_1$) mindestens 90 % der Umfangszone (12) umfasst, und einen zweiten Schleifschritt (122), der dem ersten Schleifschritt (121) nachfolgt und so ausgebildet ist, dass ein zweiter Teil ($12_2$) der Umfangszone (12) mit einer Abtragrate im Bereich zwischen 1 $\mu$m.min$^{-1}$ und 10 $\mu$m.min$^{-1}$ abgetragen wird.

7. Konturenfräsverfahren (100) nach dem vorstehenden Anspruch, wobei der erste Schleifschritt (121) auf einer Breite $L_1$, ab einer Kante der Umfangszone (12) gemessen, vorgenommen wird, und der zweite Schleifschritt (122) auf einer Breite $L_2$, ab der Kante der Umfangszone (12) gemessen, so vorgenommen wird, dass $L_1 > L_2$.

8. Konturenfräsverfahren (100) nach einem der zwei vorstehenden Ansprüche, wobei die Breiten $L_1$ und $L_2$ im Bereich zwischen 1 mm und 5 mm liegen.

9. Konturenfräsverfahren (100) nach einem der vorstehenden Ansprüche, das nach dem Stoppen (130) des Zuschneidens weiter einen Schritt des Reinigens (150) durch Nassätzen umfasst, zum Beispiel, um einen verbleibenden Teil der Umfangszone (12) abzutragen.

10. Konturenfräsverfahren (100) nach einem der Ansprüche 1 bis 8, das nach dem Stoppen (130) des Zuschneidens weiter einen Schritt des Reinigens (150) durch Trockenätzen umfasst, zum Beispiel, um einen verbleibenden Teil der Umfangszone (12) abzutragen.

**11.** Konturenfräsverfahren (100) nach einem der vorstehenden Ansprüche, wobei die Übergangsschicht (4) aus einem Material gewählt ist, ausgewählt aus: einem Siliziumoxid, Aluminiumoxid, Diamant, Siliziumnitrid, und wobei die Platte (1) aus mindestens einem Material gewählt ist, ausgewählt aus: Silizium, Germanium, einem III/V-Material, einem II/VI-Material, Siliziumkarbid.

**12.** Konturenfräsverfahren (100) nach einem der vorstehenden Ansprüche, wobei die Übergangsschicht (4) so gewählt ist, dass sie eine Dicke im Bereich zwischen 0,5 $\mu$m und 10 $\mu$m aufweist.

**Claims**

**1.** A method for trimming (100) a plate (1) having a first face and a second face opposite to the first face, said method (100) comprising the following steps:

  - Fixing (110) the plate (1) on a support (2) by means of a layer (3), called the interface layer, located between the plate (1) and the support (2), at the first face,
  - Cropping (120) a periphery area (12) of the plate (1) by grinding from the second face and in the direction of the interface layer (3),
  - Stopping (130) the cropping after removing the periphery area (12) after a total grinding time $t_{tot}$,

said method (100) being **characterised in that** an interface layer (3) is used (111), said interface layer comprising a layer (4), called a transition layer, located at least perpendicular to the periphery area (12) of the plate (1) and having a resistance to grinding greater than that of the plate (1), and **in that** stopping (130) the cropping is operated in said transition layer (4), after detecting (140) a variation in grinding resistance.

**2.** The trimming method (100) according to the preceding claim, wherein the grinding resistance of the transition layer (4) is at least five times greater than the grinding resistance of the plate (1).

**3.** The trimming method (100) according to any one of the preceding claims, wherein the total grinding time $t_{tot}$ is selected such that $t_{tot} = t_1 + t_2$, $t_1$ being a first grinding time corresponding to a grinding of the periphery area (12) of the plate (1) and $t_2$ being a second grinding time corresponding to a partial grinding of the transition layer (4), where $t_2 \neq 0$, so that stopping (130) the cropping is operated in said transition layer (4).

**4.** The trimming method (100) according to any one of the preceding claims, wherein the variation in grinding resistance is detected as an increase of one of a rated amperage and a rated torque of the motor of a grinding wheel.

**5.** The trimming method (100) according to any one of claims 1 to 3, wherein the variation in grinding resistance is detected as a decrease in a rated descent speed of a grinding wheel.

**6.** The trimming method (100) according to any one of the preceding claims, wherein the cropping (120) comprises a first grinding step (121) configured to remove a first part ($12_1$) from the periphery area (12) with a removal rate comprised between 10 $\mu$m.min$^{-1}$ and 100 $\mu$m.min$^{-1}$, said first part ($12_1$) comprising at least 90% of the periphery area (12), and a second grinding step (122) following the first grinding step (121) and configured to remove a second part ($12_2$) from the periphery area (12) with a removal rate comprised between 1 $\mu$m.min$^{-1}$ and 10 $\mu$m.min$^{-1}$.

**7.** The trimming method (100) according to the preceding claim, wherein the first grinding step (121) is carried out over a width $L_1$ taken from an edge of the periphery area (12), and the second grinding step (122) is carried out over a width $L_2$ taken from said edge of the periphery area (12), such that $L_1 > L_2$.

**8.** The trimming method (100) according to any one of the two preceding claims, wherein the widths $L_1$ and $L_2$ are comprised between 1 mm and 5 mm.

**9.** The trimming method (100) according to any one of the preceding claims further comprising, after stopping (130) the cropping, a cleaning step (150) by wet etching, for example so as to remove a remaining part from the periphery area (12).

**10.** The trimming method (100) according to any one of claims 1 to 8 further comprising, after stopping (130) the cropping, a cleaning step (150) by dry etching, for example so as to remove a remaining part from the periphery area (12).

**11.** The trimming method (100) according to any one of the preceding claims, wherein the transition layer (4) is selected from a material taken from: a silicon oxide, alumina, diamond, silicon nitride, and wherein the plate (1) is selected from at least one material taken from: silicon, germanium, a III/V material, a II/VI material, silicon carbide.

**12.** The trimming method (100) according to any one of the preceding claims, wherein the transition layer (4) is selected to have a thickness comprised between 0.5 $\mu$m and 10 $\mu$m.

FIG. 1A

FIG. 1B

FIG. 1C

FIG. 2A

FIG. 2B

FIG. 3A

FIG. 3B

100

110  Fixer une plaque à amincir sur une plaque support au moyen d'une couche d'interface

111  Utiliser une couche d'interface comprenant une couche de transition présentant une résistance au meulage supérieure à celle de la plaque à amincir

120  Rogner une zone en pourtour de la plaque à amincir par meulage

121  Enlever par meulage une première partie avec un taux d'enlèvement compris entre 10 $\mu m.min^{-1}$ et 100 $\mu m.min^{-1}$

122  Enlever par meulage une deuxième partie avec un taux d'enlèvement compris entre 1 $\mu m.min^{-1}$ et 10 $\mu m.min^{-1}$

140  Détecter une variation de résistance au meulage

130  Arrêter le rognage au bout d'un temps total $t_{tot}$

150  Nettoyer par gravure une partie restante de la zone en pourtour

FIG. 4

**EP 3 503 166 B1**

**RÉFÉRENCES CITÉES DANS LA DESCRIPTION**

**Documents brevets cités dans la description**

- WO 1996017377 A1

- EP 2348527 A1